Europäisches Patentamt

European Patent Office

Office européen des brevets

(19)

(11) Numéro de publication: **0 028 963**
**B1**

(12) **FASCICULE DE BREVET EUROPEEN**

(45) Date de publication du fascicule du brevet:
**20.07.83**

(21) Numéro de dépôt: **80401532.9**

(22) Date de dépôt: **29.10.80**

(51) Int. Cl.³: **C 01 B 13/36,** C 01 G 15/00,
C 01 F 17/00, C 30 B 29/00

(54) **Procédé de fabrication de grenat polycristallin comportant l'aluminium et/ou le gallium et/ou l'indium et au moins un élément pris dans le groupe constitué par les terres rares et l'yttrium, grenat polycristallin ainsi obtenu.**

(30) Priorité: 09.11.79 FR 7927658

(43) Date de publication de la demande:
20.05.81 Bulletin 81/20

(45) Mention de la délivrance du brevet:
20.07.83 Bulletin 83/29

(84) Etats contractants désignés:
AT BE CH DE FR GB IT LI NL SE

(56) Documents cités:
US-A-3 386 919
US-A-3 681 011

«Chemical Abstracts», vol. 83, N° 10, 8-9-1975, réf. 82187s, p. 192, Columbus, Ohio, USA.
«Chemical Abstracts», vol. 70, N° 20, 1969, réf. 92802j, p. 414, Columbus, Ohio, USA. V.I. Plotnikov et al.: «Coprecipitation of indium with rare earth hydroxides from alkali solutions».

(73) Titulaire: **RHONE-POULENC SPECIALITES CHIMIQUES,** "Les Miroirs" 18, Avenue d'Alsace, F-92400 Courbevoie (FR)

(72) Inventeur: **Boudot, Bernard, 146, boulevard Diderot, F-75012 - Paris (FR)**
Inventeur: **Nury, Georges, 28, rue Marcel Adam, F-95740 - Frepilion (FR)**

(74) Mandataire: **Savina, Jacques et al, RHONE-POULENC RECHERCHES Service Brevets Chimie et Polymères 25, Quai Paul Doumer, F-92408 Courbevoie Cedex (FR)**

**Procédé de fabrication de grenat polycristallin comportant l'aluminium et/ou le gallium et/ou l'indium et au moins un élément pris dans le groupe constitué par les terres rares et l'yttrium, grenat polycristallin ainsi obtenu.**

La présente invention concerne un procédé de fabrication de grenat polycristallin comportant l'aluminium, le gallium et/ou l'indium et au moins un élément pris dans le groupe constitué par les terres rares et l'yttrium, le grenat obtenu et les monocristaux correspondants. Plus spécialement, elle a trait à un procédé de fabrication du grenat de gadolinium/gallium $(Gd_3-Ga_5-O_{12})$, et au mono-cristal correspondant.

L'emploi de monocristaux à structure grenat, notamment comme substrats pour la fabrication des dispositifs de mémoires à bulles magnétiques, est notoirement connu.

Pour cette utilisation, les monocristaux de grenat sont essentiellement fabriqués par tirage Czochralski des oxydes mixtes polycristallins présentant la structure grenat, et ci-après dénommés grenats polycristallins.

Actuellement, les grenats polycristallins sont préparés selon trois procédés.

Le premier de ces procédés (décrit par exemple dans «Journal of Crystal Growth», *12* (1972) 3-8) consiste à opérer par mélange des différents oxydes entrant dans la composition du grenat selon les étapes suivantes:

— on calcine séparément les différents oxydes entrant dans la composition du grenat;

— on pèse les quantités fixées par la formule du grenat pour les différents oxydes;

— on mélange mécaniquement les oxydes et on densifie le mélange obtenu par pressage;

— on introduit le mélange densifié dans le creuset de tirage;

— on opère la fusion du mélange.

Ce procédé présente essentiellement deux inconvénients. D'une part, lors du chauffage du mélange, il est impossible de caractériser la structure grenat du mélange polycristallin dont l'apparition dépend du programme de montée en température mis en œuvre; d'autre part, du fait de l'évaporation de certaines sous-espèces, seules des relations empiriques permettent de connaître la composition du bain au moment du tirage en fonction de sa composition à température ambiante.

Le second de ces procédés (décrit par exemple dans le brevet allemand DE N° 2615554) consiste à opérer par mélange puis calcination des différents oxydes entrant dans la composition du grenat de façon à obtenir la structure grenat préalablement à l'opération de fusion. Les conditions de calcination (température et durée) sont déterminées en fonction des cinétiques de réactions solide-solide qui dépendent elles-mêmes essentiellement des propriétés physiques des oxydes mis en œuvre et de leurs teneurs en impuretés.

Ce procédé est le plus couramment utilisé pour la préparation des grenats polycristallins; il permet, par rapport au premier procédé, une meilleure connaissance de la composition du bain au moment du tirage, du fait de la possitiblté de caractérisation de la structure grenat. Toutefois, ce procédé présente l'inconvénient de nécessiter généralement des calcinations de longue durée qui se révèlent ne pas toujours conduire à des réactions complètes entre les oxydes. Par exemple, dans le cas d'un grenat de $Gd_3Ga_5O_{12}$, une calcination de 100 h à 1350°C du mélange de 3 mol de $Gd_2O_3$ pour 5 mol de $Ga_2O_3$ conduit à un mélange dans lequel 10% en poids du $Ga_2O_3$ n'a pas réagi.

Le troisième de ces procédés (décrit par exemple dans «Journal of Crystal Growth», *19* (1979) 204-208) consiste à décomposer thermiquement le mélange en solution des sels (carbonates, nittrates, chlorures, ammonium, sulfates, etc.) des différents éléments constituant le grenat, puis à traiter thermiquement le mélange jusqu'à l'obtention de la structure grenat.

Ce procédé présente comme inconvénient principal de conduire à des grenats impurs qui sont contaminés par les impuretés résultant de réactions de décomposition incomplètes (par exemple présence d'oxychlorure de terres rares).

La titulaire a par ailleurs mis au point un procédé de fabrication d'un oxyde mixte polycristallin présentant la structure grenat qui remédie aux inconvénients des procédés antérieurs et présente de nombreux avantages. Ce procédé consiste à précipiter les cohydroxydes des cations entrant dans la composition du grenat. Ce procédé est décrit dans la demande française ayant pour titre: «Procédé de fabrication de grenat polycristallin grenat polycristallin et monocristal correspondant», déposée au nom de la titulaire. Il comporles étapes suivantes:

1) on prépare une solution contenant les sels des cations constitutifs du grenat dans les proportions correspondant à la composition de celui-ci;

2) on opère la coprécipitation des hydroxydes correspondants par une base pour obtenir un cohydroxyde;

3) on laisse mûrir le cohydroxyde;

4) on le filtre,

5) on le lave,

6) on le sèche,

7) on le calcine à une température supérieure à la température de formation de la structure grenat désirée.

Ce procédé permet:

— d'obtenir la structure grenat par calcination à une température plus basse et pendant un temps moins long que dans les procédés de l'art antérieur;

— d'obtenir la structure grenat en dehors de l'enceinte de tirage du monocristal, ce qui assure la connaissance exacte de la composition du grenat polycristallin de départ grâce à la possibilité de caractérisation de celui-ci (par exemple par mesure du paramètre cristallin);

— d'obtenir une réaction de formation de la structure grenat absolument complète: le grenat polycristallin obtenu est pur; en particulier, il ne contient pas d'oxydes n'ayant pas réagi.

Ainsi, au cours du chauffage du grenat polycristallin dans le creuset de tirage, l'évaporation des sous-espèces de certains oxydes est beaucoup moins importante que dans les procédés de l'art antérieur. Cela se traduit lors du tirage du grenat monocristallin par les avantages supplémentaires suivants:

— la connaissance exacte de la composition du bain fondu au moment du tirage évite d'employer des relations empiriques visant à corriger les diverses évaporations;

— la limitation de la formation de sous-espèces de certains oxydes permet de restreindre les réactions entre ces sous-espèces et le creuset de tirage, ce qui permet de limiter, d'une part, l'attaque et la destruction rapide du creuset et, d'autre part, des inclusions du métal constituant le creuset dans le monocristal tiré. Ces derniers avantages sont d'une importance pratique considérable, notamment dans le cas particulier du tirage des monocristaux de $Gd_3Ga_5O_{12}$ dans un creuset d'iridium.

Cependant, bien que ce procédé présente des avantages considérables par rapport aux procédés de l'art antérieur, il n'est pas totalement satisfaisant pour obtenir des grenats polycristallins comportant l'aluminium, le gallium et/ou l'indium et au moins un élément pris dans le groupe constitué par les terres rares et l'yttrium. En effet, pour ces grenats, une coprécipitation complètement quantitative peut se révéler délicate à obtenir, et les opérations de filtration et lavage peuvent être longues à réaliser.

Par ailleurs, il est connu, d'après «Chemical Abstracts», vol. 83, 1975, référence 82187s, de fabriquer un oxyde mixte polycristallin de structure grenat par un procédé comprenant les étapes suivantes:

α) on forme une solution aqueuse contenant les sels des cations constitutifs de l'oxyde mixte dans les proportions correspondant à la composition de celui-ci,

β) on ajoute ladite solution à une base faible ($Me_4NOH$) pour coprécipiter les oxydes et/ou hydroxydes correspondants,

γ) on calcine le coprécipité obtenu à 1000°C dans l'air pendant 1 h, puis à 1400°C pendant 4 h.

On connaît, de plus, d'après le brevet US N° 3386919, un procédé de fabrication d'un oxyde mixte polycristallin de structure pérovskite par coprécipitation des hydroxydes de lanthane et d'aluminium (ou de gallium) avec l'ammoniaque à partir d'une solution contenant les sels (nitrates) correspondants, puis séchage du coprécipité et calcination pendant 5 h à 1650°C. Les solutions de nitrates sont obtenues par dissolution d'oxyde de lanthane très pur (99,997%) et d'alun très pur avec de l'acide nitrique.

La titulaire a mis au point un procédé de fabrication de tels grenats polycristallins qui résout les problèmes précités, tout en conservant les nombreux avantages du procédé par coprécipitation.

La présente invention concerne en effet un procédé de fabrication d'un grenat polycristallin comportant l'aluminium et/ou le gallium et/ou l'indium et au moins un élément pris dans le groupe constitué par les terres rares et l'yttrium du type comportant les étapes suivantes:

1) on prépare une solution contenant les sels des cations constitutifs du grenat dans les proportions correspondant à la composition de celui-ci,

2) on coprécipite les hydroxydes correspondants par une base pour obtenir un cohydroxyde,

3) on laisse éventuellement mûrir le cohydroxyde,

4) on le filtre,

5) on le lave,

6) on le sèche,

7) on le calcine à une température supérieure à la température de formation de la structure grenat désirée,

caractérisé en ce que la coprécipitation est opérée par ajout simultané de la solution de sels et de la base à une température comprise entre la température ambiante et la température d'ébullition de la solution de sels, de telle façon que le pH du milieu soit compris entre 5 et 10 et que, dans ces limites, il soit maintenu à une valeur constante pendant la durée de la coprécipitation.

La présente invention concerne également les monocristaux obtenus à partir de ces grenats polycristallins, en particulier par tirage Czochralski.

Le procédé selon la présente invention permet très aisément, d'une part, d'obtenir exactement la même composition pour le grenat que celle induite par les pesées des produits de départ et, d'autre part, d'obtenir une filtration et un lavage aisés et complètement efficaces du cohydroxyde dans un temps restreint.

Le procédé selon la présente invention est particulièrement adapté pour la fabrication des grenats polycristallins comportant l'aluminium et/ou le gallium et/ou l'indium et au moins un élément pris dans le groupe comportant les terres rares et l'yttrium.

De tels grenats répondent à la formule générale $(TR)_3M_5O_{12}$, dans laquelle TR représente au moins un élément pris dans le groupe constitué par les terres rares et l'yttrium (les terres rares étant les éléments qui portent les numéros atomiques 57 à 71 de la classification périodique), et M représente l'aluminium et/ou le gallium et/ou une combinaison de l'alluminium et/ou du gallium avec l'indium ($In^{3+}$ ne pouvant pas à priori occuper les sites tétraédriques du grenat d'après le tableau de S. Geller mentionné ci-dessus). Ainsi qu'il est bien connu de l'homme de l'art, les domaines d'existence des solutions solides des structures grenats ne sont pas toujours centrés sur la composition donnée par la formule générale, mais ils sont très légèrement décalés par rapport à celle-ci. Le procédé selon la présente invention couvre également la fabrication de telles compositions.

Le procédé de fabrication de grenat polycristallin selon la présente invention comporte une première étape de préparation d'une solution contenant les sels des cations constitutifs du grenat dans les proportions correspondant à la composition de celui-ci.

Ces sels peuvent contenir un anion minéral ou organique. On peut notamment mettre en œuvre des solutions de nitrates, de chlorures, de sulfates.

Cette solution peut avoir été préparée directement par le mélange des solutions de sels dans les proportions calculées en fonction de la composition du grenat désiré ou bien avoir été préparée selon le procédé comportant les étapes suivantes:

a) on calcine les oxydes des cations entrant dans la composition du grenat,

b) on pèse les quantités d'oxydes fixées par la formule du grenat,

c) on dissout les oxydes dans un acide fort,

d) on mélange les solutions de sels obtenues.

Selon l'étape a de ce procédé, on calcine les oxydes entrant dans la composition du grenat. La température et la durée de la calcination sont choisies de telle façon qu'elles correspondent, pour l'oxyde, à la perte de poids maximale. Les conditions de calcination choisies doivent évidemment permettre l'attaque ultérieure de l'oxyde calciné en milieu acide fort.

Selon l'étape b de ce procédé, on pèse les quantités d'oxydes fixées par la formule du grenat. La précision de la pesée est adaptée en fonction de la précision de formule du grenat que l'on veut obtenir; il peut ainsi être nécessaire, pour certaines formules, d'opérer avec une précision de 0,1%.

Selon l'étape c de ce procédé, on dissout les oxydes dans un acide fort. La dissolution est opérée séparément ou simultanément lorsque les conditions de dissolution de ces oxydes sont voisines. L'acide mis en œuvre peut être pur ou dilué. L'acide peut notamment être choisi parmi le groupe comprenant: l'acide chlorhydrique, l'acide nitrique, l'acide sulfurique, l'acide perchlorique. On utilise avantageusement l'acide chlorhydrique ou l'acide nitrique.

Les conditions de dissolution varient selon les acides mis en œuvre. La rapidité de la dissolution complète des oxydes dépend notamment de la nature de l'acide, de sa concentration et de la température. De bonnes conditions sont généralement obtenues lorsque la dissolution est opérée avec des acides purs concentrés à l'ébullition, une concentration supérieure à environ 5N se montre avantageuse. La dimension des particules d'oxyde n'est pas un facteur critique selon le procédé de l'invention. Toutefois, si l'on désire une dissolution assez rapide, il est avantageux de mettre en œuvre des particules ayant une granulométrie assez fine et, de préférence, dont le diamètre est inférieur à environ 400 $\mu$; plus particulièrement, des particules ayant un diamètre compris entre environ 1 et 50 $\mu$ conduisent à une mise en œuvre aisée.

Le mélange des solutions de sels obtenues est effectué lorsque les oxydes ont été dissous séparément.

Selon la deuxième étape du procédé selon l'invention, on effectue la coprécipitation des hydroxydes correspondants par une base pour obtenir un cohydroxyde en opérant par ajout simultané de la solution de sels et de la base à une température comprise entre la température ambiante et la température d'ébullition de la solution de sels, de telle façon que le pH du milieu soit compris entre 5 et 10 et que, dans ces limites, il soit maintenu à une valeur constante pendant la durée de la coprécipitation.

La coprécipitation est opérée par une base et sous agitation. Comme base, on utilisera de préférence une base faible telle que l'ammoniaque, l'urée, l'hexaméthylènetétramine, le carbamate d'ammonium, etc.; la concentration de la base est supérieure de préférence à 5N.

La coprécipitation est opérée par ajout simultané de la solution de sels et de la base à une température comprise, de préférence, entre 80°C et la température d'ébullition de la solution de sels, et, plus particulièrement, entre 95 et 1.

Le pH du milieu doit être compris entre 5 et 10. Un moyen commode pour démarrer la coprécipitation dans ces conditions est de faire arriver simultanément la base et la solution de sels dans une solution du sel de la base utilisée et de l'acide correspondant au sel de départ. Dans l'intervalle de pH considéré, celui-ci doit être maintenu à une valeur constante pendant toute la durée de la coprécipitation. Pour la fabrication des grenats polycristallins comportant le gallium, la valeur du pH doit, de préférence, être maintenue constante à environ $\pm$ 0,05 unité de pH.

Pour une température donnée, la valeur du pH à mettre en œuvre est celle pour laquelle on ne redissout pas d'hydroxyde d'aluminium et/ou de gallium et/ou d'indium, et pour laquelle la précipitation des hydroxydes de terres rares et d'yttrium est complète. Autrement dit, pour une température donnée, la valeur du pH à mettre en œuvre est celle qui correspond à la composition visée pour le grenat final calciné d'après la courbe de composition du grenat final calciné en fonction du pH de coprécipitation des hydroxydes. Dans le cas particulier de la fabrication d'un grenat de gadolinium/gallium $Gd_3Ga_5O_{12}$, cette valeur est de 6,50 $\pm$ 0,05 lorsque l'on effectue la coprécipitation dans les conditions préférées à une température comprise entre environ 95 et 100°C, et de 8,10 $\pm$ 0,05 lorsque l'on effectue la coprécipitation à une température comprise entre 20 et 25°C.

Selon la troisième étape du procédé selon l'invention, on laisse mûrir le cohydroxyde obtenu pendant une durée comprise entre 1 et 20 h. Si la précipitation du cohydroxyde est complète, cette étape de mûrissement peut éventuellement être supprimée.

Le mûrissement est avantageusement opéré dans les mêmes conditions de température et de pH que la précipitation. Dans le cas particulier de la fabrication d'un grenat de gadolinium/gallium $Gd_3Ga_5O_{12}$, le mûrissement est, de préférence, effectué à 95-100°C à pH=6,50 $\pm$ 0,05.

Selon la quatrième étape du procédé de l'invention, on opère la filtration du cohydroxyde obtenu sous pression ou sous vide. L'élément filtrant mis en œuvre doit présenter, de préférence, une porosité très faible de 1 à 5 µm. Ainsi qu'il est bien connu de l'homme de l'art, la filtrabilité du cohydroxyde peut être mise en œuvre en ajoutant au précipité, avant ou après le mûrissement, un agent floculant décomposable à basse température.

Selon la cinquième étape du procédé de l'invention, on lave ensuite le cohydroxyde. Le lavage est, de préférence, opéré avec de l'eau jusqu'à l'obtention d'eaux de lavage présentant un pH voisin de la neutralité. Ce lavage a essentiellement pour but d'éliminer les sels adsorbés, il peut notamment s'effectuer soit par transfert à travers le gâteau de cohydroxyde d'un certain volume d'eau, soit par remise en suspension du gâteau de filtration.

Le procédé selon la présente invention permet ainsi de diviser par un facteur d'environ 6 le temps nécessaire aux opérations de filtration et de lavage lorsque l'on opère par coprécipitation classique des hydroxydes à température ambiante par ajout de la solution de sels à la base.

Selon la sixième étape du procédé de l'invention, on sèche ensuite le cohydroxyde à l'air ou sous vide à des températures comprises entre 100 et 200° C pendant 10 à 48 h. Ce séchage est, de préférence, opéré à l'étuve à une température comprise entre 110 et 150° C pendant un temps compris entre 10 et 30 h.

Selon la septième étape du procédé de l'invention, on calcine le produit séché à une température supérieure à la température de formation de la structure du grenat considéré.

Pour un grenat déterminé, la température et la durée de la calcination dépendent, d'une part, de la température de formation de la structure grenat à partir du cohydroxyde, température que l'homme de l'art détermine sans difficulté à partir des courbes d'analyse thermique différentielle obtenues sur le produit séché et, d'autre part, des conditions d'utilisation ultérieure du grenat polycristallin calciné. Dans ces conditions, une température de calcination comprise entre 800 et 1500° C et un temps compris entre 1 à 30 h conviennent généralement. La calcination est généralement effectuée sous air ou sous atmosphère inerte.

Le grenat polycristallin obtenu est caractérisable par diffraction X: on peut vérifier sa structure grenat, contrôler son homogénéité en vérifiant qu'aucune autre structure n'est visible (en particulier, on ne détecte pas d'oxydes n'ayant pas réagi) et mesurer son paramètre de réseau. .

La connaissance exacte de la composition du grenat polycristallin est un des avantages du procédé selon l'invention pour le tirage subséquent du monocristal.

Par ailleurs, la microscopie électronique à balayage révèle l'existence de cristaux élémentaires dont les dimensions sont de l'ordre de quelques micromètres et la présence d'agglomérats de ces cristaux rassemblés selon un assemblage compact.

La surface spécifique du grenat polycristallin obtenu selon le procédé de la présente invention est généralement faible, sa masse volumique est généralement comprise entre environ 6 et 7.

La présente invention concerne également les monocristaux obtenus à partir des grenats polycristallins fabriqués selon le procédé décrit ci-dessus. Les monocristaux de grenat peuvent notamment être fabriqués à l'aide de la technique connue de tirage de cristal selon Czochralski.

Les monocristaux à structure grenat obtenus à partir des grenats polycristallins de l'invention sont utilisables dans tous les domaines où de tels matériaux présentent de l'intérêt et, en particulier, dans l'électronique, comme substrats pour la fabrication des dispositifs de mémoires à bulles magnétiques.

Les très nombreux avantages de l'invention tant au niveau du grenat polycristallin que du tirage du monocristal ont été donnés ci-dessus.

Les exemples qui vont suivre illustrent l'invention sans en limiter la portée.

*Exemple 1 :*

Cet exemple illustre la préparation du grenat polycristallin de gallium/gadolinium selon le procédé de l'invention.

La composition stœchiométrique de ce grenat est $Gd_{3,00}Ga_{5,00}O_{12}$, et il existe une solution solide de la structure grenat qui n'est pas centrée sur cette composition, mais décalée vers les compositions riches en gadolinium. Plus particulièrement, la composition à fusion congruente (voisine de $Gd_{3,04}Ga_{4,96}O_{12}$) est différente de la composition stœchiométrique, et il est préférable, dans ces conditions, lorsque l'on souhaite tirer le grenat monocristallin par la méthode de Czochralski, de partir d'un grenat polycristallin dont la composition est comprise entre la congruence et la stœchiométrie.

L'exemple ci-après est relatif à la préparation du grenat polycristallin de composition $Gd_{3,011}Ga_{4,99}O_{12}$. On a opéré selon les étapes suivantes:

1a)  On calcine l'oxyde de gadolinium $Gd_2O_3$ et l'oxyde de gallium $Ga_2O_3$ pendant 15 h à 1200° C;

1b)  On pèse 11347,6 g de $Gd_2O_3$ calciné et 9727,4 g de $Ga_2O_3$ calciné;

1c)  On dissout l'oxyde de gadolinium dans 34 l d'acide nitrique 6,4N dans un réacteur en Pyrex de 100 l muni d'un agitateur revêtu de polytétrafluoroéthylène (PTFE) : la dissolution est rapide et exothermique; on a opéré avec un condenseur de 1 m² à reflux total;

on dissout l'oxyde de gallium dans 64 l d'acide nitrique 6,4N dans un réacteur en Pyrex de 100 l chauffé et muni d'un agitateur revêtu de PTFE: la dissolution complète à 100° C sous reflux total (condenseur de 1 m²) a duré 8 h;

1d)  on mélange et on homogénéise les deux solutions de nitrate dans une cuve de 120 l en polypropylène.

2)  On coprécipite l'hydroxyde mixte de gallium et de gadolinium dans deux réacteurs en Pyrex de 200 l chacun, munis d'un agitateur revêtu de PTFE, d'une sonde de mesure du pH et d'une sonde thermométrique et alimentés par l'intermédiaire de deux pompes doseuses.

Les conditions expérimentales de la coprécipitation sont les suivantes:

— la température est comprise entre 20 et 25°C;

— les deux réacteurs ayant été préalablement remplis de 30 l d'une solution de nitrate d'ammonium $NH_4NO_3$, on fait arriver simultanément dans chacun des deux réacteurs la solution de nitrates de gallium et de gadolinium et une solution d'ammoniaque 6N. Dans chacun des deux réacteurs, le débit des deux pompes doseuses d'arrivée des réactifs est asservi par la régulation de pH à la valeur consigne $8,10 \pm 0,05$;

— le débit moyen de la solution de nitrates est de 10 l/h; la durée totale de la coprécipitation dans les deux réacteurs est ainsi d'environ 5 h;

— le volume d'ammoniaque utilisé est de 105 l;

— on a ajouté dans chaque réacteur 5 l de solution aqueuse à 0,1% d'agent floculant Flocogil AD 10 (marque déposée).

3) On laisse mûrir le cohydroxyde de gallium/-gadolinium pendant 15 h à la température ambiante à un pH compris entre 8,0 et 8,2 sous agitation.

4) On filtre le cohydroxyde sous vide sur un filtre type Nutche de 140 cm de diamètre, l'élément filtrant est une toile de polypropylène dont la porosité est d'environ 3 μ. L'épaisseur du gâteau de filtration obtenu pour un réacteur est de 40 mm.

5) On effectue un lavage séparé du gâteau de chaque réacteur par transfert d'eau à travers celui-ci avec $5 \times 50$ l d'eau.

6) On sèche à l'étuve sous vide le gâteau pendant 15 h à 130°C; la perte en poids de celui-ci est d'environ 75%.

7) On calcine le produit obtenu après émottage pendant 5 h à 1350°C dans des creusets en alumine frittée de haute pureté, sous argon. La température de calcination utilisée est très supérieure à la température de formation de la structure grenat à partir du cohydroxyde qui est de 820°C (déterminée à partir de la courbe d'analyse thermique différentielle), mais se révèle avantageuse pour donner un grenat polycristallin directement fusible lors d'un tirage Czochralski sans autre traitement.

La perte de poids au cours de la calcination est de 18,2% et on obtient 20 320 g de grenat polycristallin avec un rendement de 96%.

La caractérisation en diffraction X du produit obtenu révèle que seule la structure grenat est visible (pas de structure $Ga_2O_3$ et/ou de structure $Gd_2O_3$).

La mesure du paramètre de réseau donne $a = 12,378$ Å, ce qui correspond bien à la composition $Gd_{3,01}Ga_{4,99}O_{12}$ désirée.

Le monocristal obtenu par tirage Czolchralski à partir de ce grenat polycristallin est absolument parfait. Le tirage s'effectue avec tous les avantages donnés dans le présent brevet.

*Exemple 2:*

Cet exemple est relatif à la préparation du grenat $Gd_{3,01}Ga_{4,99}O_{12}$ dans les conditions préférées du procédé selon l'invention.

Les étapes 1a à 1d sont identiques à celles données dans l'exemple 1.

2) L'étape de coprécipitation est opérée dans les deux mêmes réacteurs que selon l'exemple 1; les conditions expérimentales de la coprécipitation sont les suivantes:

— la température est de 100°C avec reflux total;

— les deux réacteurs ayant été préalablement remplis de 30 l de solution de nitrate d'ammonium $NH_4NO_3$, on fait arriver simultanément dans chacun des deux réacteurs la solution de nitrates de gallium et de gadolinium et une solution d'ammoniaque 6N. Dans chacun des deux réacteurs, le débit des deux pompes doseuses d'arrivée des réactifs est asservi par la régulation de pH à la valeur consigne $6,50 \pm 0,05$;

— le débit moyen de la solution de nitrates est de 13 l/h, la durée totale de la coprécipitation dans les deux réacteurs étant ainsi d'environ 4 h;

— le volume d'ammoniaque utilisé est de 104 l.

3) On laisse mûrir le cohydroxyde de gallium/-gadolinium pendant 4 h à 100°C à un pH compris entre 6,40 et 6,60 sous agitation.

4) On filtre le cohydroxyde à chaud sous vide sur un filtre type Nutche de 140 cm de diamètre, l'élément filtrant est une toile de polypropylène dont la porosité est d'environ 3 μ; la filtration est beaucoup plus aisée que pour l'exemple 1, et la totalité du cohydroxyde des deux réacteurs est aisément filtrée en une seule opération.

5) On opère le lavage du gâteau de filtration par transfert d'eau à travers celui-ci avec $5 \times 100$ l d'eau.

A quantités de cohydroxyde traité égales, les opérations de filtration et de lavage ont été deux fois plus rapides que celles réalisées selon l'exemple 1.

6) On sèche à l'étuve sous vide le gâteau pendant 15 h à 130°C; la perte en poids de celui-ci est d'environ 75%.

7) On calcine le produit obtenu après émottage pendant 5 h à 1350°C et on obtient 20 300 g de grenat polycristallin avec un rendement supérieur à 96%.

La caractérisation du grenat polycristallin et les propriétés du monocristal obtenu sont identiques à celles données à l'exemple 1.

*Exemple 3: exemple comparatif.*

Cet exemple illustre l'un des avantages du procédé selon l'invention par rapport au procédé de l'art antérieur couramment utilisé pour la préparation des grenats polycristallins.

On a préparé le grenat polycristallin de compositions $Gd_{3,01}Ga_{4,99}O_{12}$ selon les étapes suivantes:

1) On calcine l'oxyde de gadolinium $Gd_2O_3$ pendant 15 h à 1200°C et l'oxyde de gallium $Ga_2O_3$ pendant 15 h à 1200°C.

2) On pèse 11 347,6 g de $Gd_2O_3$ calciné et 9727,4 g de $Ga_2O_3$ calciné.

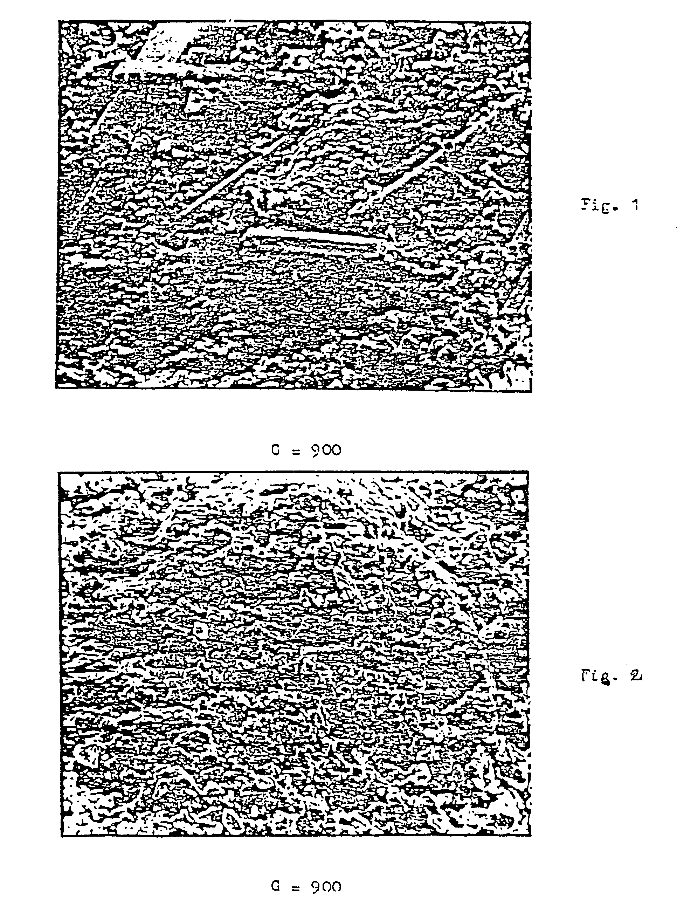

3) On mélange ces oxydes, puis on calcine 100 h à 1350°C. On obtient un grenat polycristallin dans lequel 10% en poids de $Ga_2O_3$ n'a pas réagi. L'analyse de ce produit par microscopie électronique à balayage révèle l'existence de cristaux

aciculaires de $Ga_2O_3$ n'ayant pas réagi, la photo donnée à la fig. 1 illustre un tel produit.

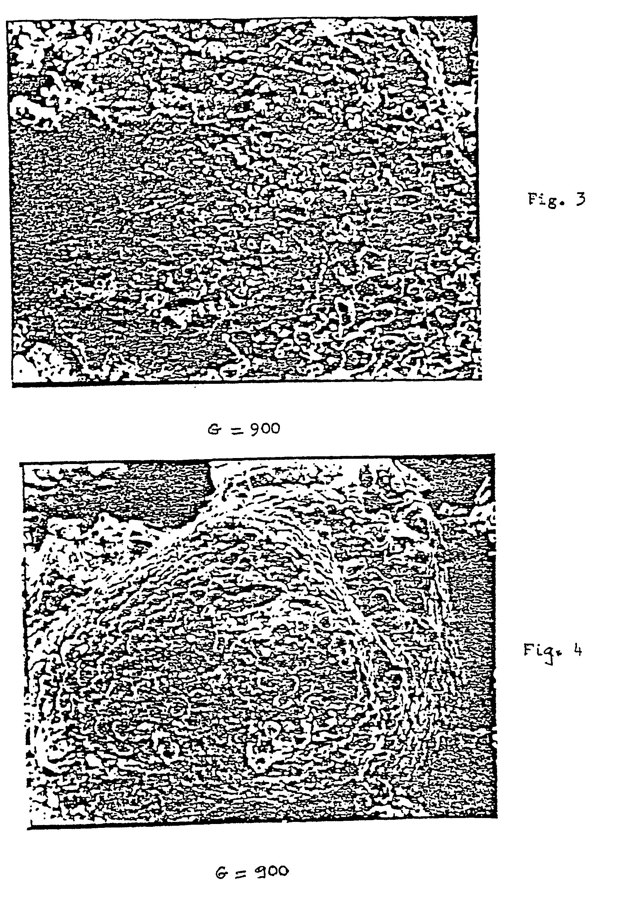

Par comparaison, les grenats polycristallins obtenus selon le procédé de l'invention décrit aux exemples 1 et 2 se révèlent présenter une structure sans inclusion. Des photos de ces grenats, qui ont été obtenues par microscopie électronique à balayage, sont données aux fig. 2, 3, 4.

*Exemple 4: exemple comparatif.*

Cet exemple illustre l'un des avantages apportés par le procédé de l'invention par rapport au procédé général par coprécipitation par ajout de la solution de nitrates à l'ammoniaque jusqu'à un pH déterminé.

Les étapes 1a à 1d sont identiques à celles données à l'exemple 1.

2) L'étape de coprécipitation est opérée dans les mêmes réacteurs que selon l'exemple 1; les conditions expérimentales sont les suivantes:

— la température est de 20-25°C;

— on ajoute la solution de nitrates de gallium et de gadolinium dans une solution d'ammoniaque 6N jusqu'à l'obtention d'un pH égal à 8,70.

3) On laisse mûrir le cohydroxyde obtenu pendant 3 h à température ambiante sous agitation.

Les opérations de filtration, lavage, séchage et calcination sont similaires à celles données dans l'exemple 1.

La durée des opérations de filtration et de lavage a été multipliée par un facteur d'environ 6 par rapport à celles effectuées selon l'exemple 2.

Par ailleurs, le procédé selon l'invention permet d'obtenir plus aisément une grande précision sur la composition du grenat final que lorsque l'on opère selon le procédé général qui a été illustré ci-dessus.

## Revendications

1. Procédé de fabrication de grenat polycristallin comportant l'aluminium et/ou le gallium et/ou l'indium et au moins un élément pris dans le groupe constitué par les terres rares et l'yttrium, du type comportant les étapes suivantes:

1) on prépare une solution contenant les sels des cations constitutifs du grenat dans les proportions correspondant à la composition de celui-ci,

2) on coprécipite les hydroxydes correspondants par une base pour obtenir un cohydroxyde,

3) on laisse éventuellement mûrir le cohydroxyde;

3) on laisse éventuellement mûrir le cohydroxyde;

4) on le filtre;

5) on le lave;

6) on le sèche;

7) on le calcine à une température supérieure à la température de formation de la structure grenat désirée,

caractérisé en ce que la coprécipitation est opérée par ajout simultané de la solution de sels et de la base à une température d'ébullition de la solution de sels, de telle façon que le pH du milieu soit compris entre 5 et 10 et que, dans ces limites, il soit maintenu à une valeur constante pendant la durée de la coprécipitation.

2. Procédé selon la revendication 1, caractérisé en ce que, selon la première étape, les sels sont choisis parmi le groupe comportant les nitrates, les chlorures, les sulfates.

3. Procédé selon la revendication 1, caractérisé en ce que, selon la première étape, la solution contenant les sels des cations constitutifs du grenat a été préparée selon le procédé comportant les étapes suivantes:

a) on calcine les oxydes des cations entrant dans la composition du grenat;

b) on pèse les quantités d'oxydes fixées par la formule du grenat;

c) on dissout les oxydes dans un acide fort;

d) on mélange les solutions de sels obtenues.

4. Procédé selon la revendication 3, caractérisé en ce que, selon l'étape a, la température et la durée de la calcination des oxydes entrant dans la composition du grenat sont choisies de façon à correspondre, pour l'oxyde, à une perte de poids maximale.

5. Procédé selon la revendication 3, caractérisé en ce que, selon l'étape c, on dissout séparément les oxydes dans un acide fort.

6. Procédé selon la revendication 3, caractérisé en ce que, selon l'étape c, on dissout simultanément les oxydes dans un acide fort.

7. Procédé selon l'une des revendications 3, 5 ou 6, caractérisé en ce que l'acide fort est mis en œuvre pur ou dilué, et est choisi parmi le groupe comprenant: l'acide chlorhydrique, l'acide nitrique, l'acide sulfurique, l'acide perchlorique.

8. Procédé selon l'une des revendications 3, 5, 6 ou 7, caractérisé en ce que la dissolution est opérée avec l'acide pur concentré à l'ébullition.

9. Procédé selon la revendication 1, caractérisé en ce que, selon la seconde étape, la base est une base faible, de préférence choisie parmi le groupe comportant l'ammoniaque, l'urée, l'hexaméthyl-ènetétramine, le carbamate d'ammonium.

10. Procédé selon la revendication 1, caractérisé en ce que, selon la seconde étape, la concentration de la base est supérieure à 5N.

11. Procédé selon la revendication 1, caractérisé en ce que, selon la seconde étape, la température est comprise entre 80°C et la température d'ébullition de la solution de sels, et plus particulièrement entre 95 et 100°C.

12. Procédé selon la revendication 1, caractérisé en ce que, selon la troisième étape, le mûrissement est effectué dans les mêmes conditions de température et de pH que lors de l'étape de coprécipitation pendant 1 à 20 h.

13. Procédé selon la revendication 1, caractérisé en ce que, selon la quatrième étape, on filtre le cohydroxyde sous pression ou sous vide, l'élément filtrant mis en œuvre ayant de préférence une porosité de 1 à 5 µm.

14. Procédé selon la revendication 1, caractérisé en ce que, selon la cinquième étape, on lave le cohydroxyde avec de l'eau jusqu'à l'obtention d'eaux de lavage présentant un pH voisin de la neutralité.

15. Procédé selon la revendication 1, caractérisé en ce que, selon la sixième étape, on sèche le cohydroxyde à l'air ou sous vide à une température comprise entre 100 et 200° C pendant 10 à 48 h.

16. Procédé selon la revendication 1, caractérisé en ce que, selon la septième étape, on calcine le cohydroxyde à une température comprise entre 800 et 1500° C pendant 1 à 30 h.

17. Grenat polycristallin obtenu selon le procédé de l'une des revendications précédentes, caractérisé en ce qu'il est constitué de cristaux dont les dimensions élémentaires sont de l'ordre de quelques micromètres, et en ce qu'il comporte des agglomérats de ces cristaux rassemblés selon un assemblage compact.

## Patentansprüche

1. Verfahren zur Herstellung von polykristallinem Granat, enthaltend Aluminium und/oder Gallium und/oder Indium und wenigstens ein Element aus der Gruppe der seltenen Erden und Yttrium mit den folgenden Stufen:

1) man stellt eine Lösung her, die die Salze der Kationenbestandteile des Granats in den der Zusammensetzung des Granats entsprechenden Mengenverhältnissen aufweist,

2) man fällt die entsprechenden Hydroxide gemeinsam mit einer Base, um ein Cohydroxid zu erhalten,

3) man lässt das Cohydroxid gegebenenfalls reifen,

4) man filtriert es,

5) man wäscht est,

6) man trocknet es,

7) man calciniert es bei einer Temperatur über der für die Bildung der gewünschten Granatstruktur erforderlichen Temperatur,

dadurch gekennzeichnet, dass die Copräzipitation unter gleichzeitiger Zugabe der Salzlösung und der Base bei einer Temperatur zwischen Raumtemperatur und der Siedetemperatur der Salzlösung in der Weise vorgenommen wird, dass der pH-Wert des Reaktionsgemisches zwischen 5 und 10 liegt, und dass er in diesen Grenzen während der Dauer der Copräzipitation auf einem konstanten Wert gehalten wird.

2. Verfahren nach Anspruch 1, dadurch gekennzeichnet, dass gemäss der ersten Stufe die Salze aus der die Nitrate, Chloride und Sulfate umfassenden Gruppe ausgewählt sind.

3. Verfahren nach Anspruch 1, dadurch gekennzeichnet, dass gemäss der ersten Stufe die Lösung, die die Salze der wesentlichen Kationen des Granats enthält, nach dem die folgenden Stufen umfassenden Verfahren hergestellt wurde:

a) man calciniert die Oxide der Kationen, entsprechend der Zusammensetzung von Granat,

b) man wiegt die durch die Formel von Granat vorgegebenen Mengen der Oxide ab,

c) man löst die Oxide in einer starken Säure,

d) man mischt die Lösungen der erhaltenen Salze.

4. Verfahren nach Anspruch 3, dadurch gekennzeichnet, dass gemäss der Stufe a die Temperatur und die Dauer der Calcinierung der Oxide in der Zusammensetzung von Granat in der Weise gewählt sind, dass sie den höchsten Gewichtsverlust des Oxids ergeben.

5. Verfahren nach Anspruch 3, dadurch gekennzeichnet, dass man gemäss Stufe c die Oxide getrennt in einer starken Säure auflöst.

6. Verfahren nach Anspruch 3, dadurch gekennzeichnet, dass man gemäss Stufe c die Oxide gleichzeitig in einer starken Säure auflöst.

7. Verfahren nach einem der drei Ansprüche 3, 5 oder 6, dadurch gekennzeichnet, dass die starke Säure rein oder verdünnt eingesetzt wird und aus der Salzsäure, Salpetersäure, Schwefelsäure und Perchlorsäure umfassenden Gruppe ausgewählt ist.

8. Verfahren nach einem der vier Ansprüche 3, 5, 6 oder 7, dadurch gekennzeichnet, dass die Auflösung mit reiner konzentrierter siedender Säure durchgeführt wird.

9. Verfahren nach Anspruch 1, dadurch gekennzeichnet, dass gemäss der zweiten Stufe die Base eine schwache Base, vorzugsweise ausgewählt aus der Ammoniak-, Harnstoff-, Hexamethylentetramin und Ammoniumcarbamat umfassenden Gruppe ist.

10. Verfahren nach Anspruch 1, dadurch gekennzeichnet, dass gemäss der zweiten Stufe die Konzentration der Base über 5N ist.

11. Verfahren nach Anspruch 1, dadurch gekennzeichnet, dass gemäss der zweiten Stufe die Temperatur zwischen 80° C und der Siedetemperatur der Salzlösung, insbesondere zwischen 95 und 100° C, liegt.

12. Verfahren nach Anspruch 1, dadurch gekennzeichnet, dass gemäss der dritten Stufe die Reifung unter den gleichen Temperatur- und pH-Bedingungen wie in der Copräzipitationsstufe während 1 bis 20 h durchgeführt wird.

13. Verfahren nach Anspruch 1, dadurch gekennzeichnet, dass gemäss der vierten Stufe das Cohydroxid unter Druck oder unter Vakuum filtriert wird, wobei das verwendete Filterelement vorzugsweise eine Porosität von 1 bis 5 µm hat.

14. Verfahren nach Anspruch 1, dadurch gekennzeichnet, dass man gemäss der fünften Stufe das Cohydroxid mit Wasser wäscht, bis das Waschwasser einen pH-Wert in der Nähe der Neutralität aufweist.

15. Verfahren nach Anspruch 1, dadurch gekennzeichnet, dass man gemäss der sechsten Stufe das Cohydroxid an der Luft oder unter Vakuum bei einer Temperatur zwischen 100 und 200° C 10 bis 48 h trocknet.

16. Verfahren nach Anspruch 1, dadurch gekennzeichnet, dass man gemäss der siebten Stufe die Cohydroxide bei einer Temperatur zwischen 800 und 1500° C 1 bis 30 h calciniert.

17. Polykristalliner Granat, erhaltend nach dem Verfahren von irgendeinem der vorangehenden Ansprüche, dadurch gekennzeichnet, dass er aus Kristallen besteht, deren Elementarabmessungen in der Grössenordnung von einigen Mikrometern sind, und dass er Agglomerate enthält, in denen diese Kristalle in dichter Packung zusammengefügt sind.

## Claims

1. Process for the manufacture of polycristalline garnet containing aluminium and/or gallium and/or indium and at least one element taken from the group comprising the rare earths and yttrium, the process being of the type comprising the following steps:

(1) a solution containing the salts of the constituent cations of the garnet, in the proportions corresponding to the composition of the latter, is prepared;

(2) the corresponding hydroxides are coprecipitated by means of a base in order to give a co-hydroxide;

(3) if appropriate, the co-hydroxide is left to age;

(4) it is filtered off;

(5) it is washed;

(6) it is dried, and

(7) it is then calcined at a temperature above the temperature for the formation of the desired garnet structure,

characterized in that the co-precipitation is carried out by simultaneously adding the solution of salts and the base at a temperature between ambient temperature and the boiling point of the solution of salts, in such a way that the pH of the medium is between 5 and 10 and that, within these limits, it is kept at a constant value throughout the co-precipitation.

2. Process according to claim 1, characterized in that, in the first step, the salts are chosen from amongst the group comprising nitrates, chlorides and sulphates.

3. Process according to claim 1, characterized in that, in the first step, the solution containing the salts of the constituent cations of the garnet has been prepared by the process comprising the following steps:

(a) the oxides of the cations forming part of the composition of the garnet are calcined;

(b) the amounts of oxides fixed by the formula of the garnet are weighed out;

(c) the oxides are dissolved in a strong acid, and

(d) the resulting solutions of salts are mixed.

4. Process according to claim 3, characterized in that, in step (a), the calcination temperature and the calcination time of the oxides forming part of the garnet are chosen so as to correspond to a maximum loss in weight for the oxide.

5. Process according to claim 3, characterized in that, in step (c), the oxides are dissolved separately in a strong acid.

6. Process according to claim 3, characterized in that, in step (c), the oxides are dissolved simultaneously in a strong acid.

7. Process according to claims 3, 5 or 6, characterized in that the strong acid is used pure or dilute and is chosen from amongst the group comprising hydrochloric acid, nitric acid, sulphuric acid and perchloric acid.

8. Process according to claims 3, 5, 6 or 7, characterized in that the dissolution is carried out with the pure concentrated acid at the boil.

9. Process according to claim 1, characterized in that, in the second step, the base is a weak base which is preferably chosen from amongst the group comprising ammonia, urea, hexamethylenetetramine and ammonium carbamate.

10. Process according to claim 1, characterized in that, in the second step, the concentration of the base is above 5N.

11. Process according to claim 1, characterized in that, in the second step, the temperature is between 80°C and the boiling point of the solution of salts, and more particularly between 95 and 100°C.

12. Process according to claim 1, characterized in that, in the third step, the ageing is carried out under the same temperature and pH conditions as during the coprecipitation step, for 1 to 20 h.

13. Process according to claim 1, characterized in that, in the fourth step, the co-hydroxide is filtered off under pressure or in vacuo, the filtering element used preferably having a pore size of 1 to 5 μm.

14. Process according to claim 1, characterized in that, in the fifth step, the co-hydroxide is washed with water until the wash waters obtained have a pH in the region of neutrality.

15. Process according to claim 1, characterized in that, in the sixth step, the co-hydroxide is dried in air or in vacuo at a temperature of between 100 and 200°C for 10 to 48 h.

16. Process according to claim 1, characterized in that, in the seventh step, the co-hydroxide is calcined at a temperature of between 800 and 1,500°C for 1 to 30 h.

17. Polycristalline garnet obtained by the process of any one of the preceding claims, characterized in that it consists of crystals, the elementary dimensions of which are of the order of a few micrometres, and in that it contains agglomerates of these crystals grouped together in a compact assembly.

Fig. 1

G = 900

Fig. 2

G = 900

Fig. 3

G = 900

Fig. 4

G = 900